(19) Europäisches Patentamt / European Patent Office / Office européen des brevets

(11) **EP 3 936 763 B1**

(12) **FASCICULE DE BREVET EUROPEEN**

(45) Date de publication et mention
de la délivrance du brevet:
**01.07.2026 Bulletin 2026/27**

(21) Numéro de dépôt: **20305768.2**

(22) Date de dépôt: **07.07.2020**

(51) Classification Internationale des Brevets (IPC):
*F21V 9/30* *(2018.01)*

(52) Classification Coopérative des Brevets (CPC):
**G02B 6/0028; G02B 6/0003; G02B 6/0068;**
G02B 6/4298; H10H 20/8514; H10H 20/8515

(54) **CONCENTRATEUR LUMINESCENT**

LUMINESZENZKONZENTRATOR

LUMINESCENT CONCENTRATOR

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(43) Date de publication de la demande:
**12.01.2022 Bulletin 2022/02**

(73) Titulaires:
 • **Centre National de la Recherche Scientifique
 75016 Paris (FR)**
 • **Institut d'Optique Théorique et Appliquée
 91120 Palaiseau (FR)**
 • **Université Paris-Saclay
 91190 Gif-sur-Yvette (FR)**

(72) Inventeurs:
 • **BALEMBOIS, François
 91127 PALAISEAU CEDEX (FR)**

 • **PICHON, Pierre
 91127 PALAISEAU CEDEX (FR)**

(74) Mandataire: **IPAZ
 Parc Les Algorithmes
 Bâtiment Platon
 91190 Saint Aubin (FR)**

(56) Documents cités:
 EP-A1- 2 947 484   WO-A1-2008/042703
 WO-A1-2016/063047   WO-A1-2020/089246
 US-A1- 2007 280 622   US-A1- 2013 294 064
 US-B1- 8 384 107

 • DICK K. G. DE BOER ET AL: "High-brightness
 source based on luminescent concentration",
 OPTICS EXPRESS, vol. 24, no. 14, 11 July 2016
 (2016-07-11), US, pages A1069, XP055648883,
 ISSN: 1094-4087, DOI: 10.1364/OE.24.0A1069

## Description

## Domaine technique :

La présente invention concerne le domaine des concentrateurs luminescents pompés par diodes électroluminescentes (LED), et plus particulièrement des concentrateurs luminescents pompés par LED utilisés comme source de lumière.

## Technique antérieure :

Les diodes électroluminescentes (LED) possèdent de nombreuses applications dans le domaine de l'éclairage. Cependant, la luminance des LED est limitée à des valeurs ne convenant pas à certaines applications.
Une solution pour augmenter la luminance des LED est d'utiliser des concentrateurs de lumière pompés par LED (voir par exemple Barbet, Adrien, et al. "Light-emitting diode pumped luminescent concentrators: a new opportunity for low-cost solid-state lasers." Optica 3.5 (2016): 465-468.). Ce concentrateur est, par exemple, un cristal fluorescent dans le visible (rouge-orange) comme le Ce:YAG qui absorbe dans le bleu (vers 450 nm), à une longueur d'onde où les LED sont très performantes. Le cristal est taillé sous la forme d'un plan, tapissé par des centaines (voire des milliers) de LED sur les deux grandes surfaces et avec une émission par les tranches. Ces concentrateurs permettent d'obtenir des valeurs de luminance 10 à 20 fois plus élevée que celle d'une LED.
EP 2 947 484 A1 et US 2007/280622 A1 divulguent un concentrateur de lumière planaire comprenant un cristal luminescent, avec un miroir sur une face et un miroir partiel sur la face opposée.

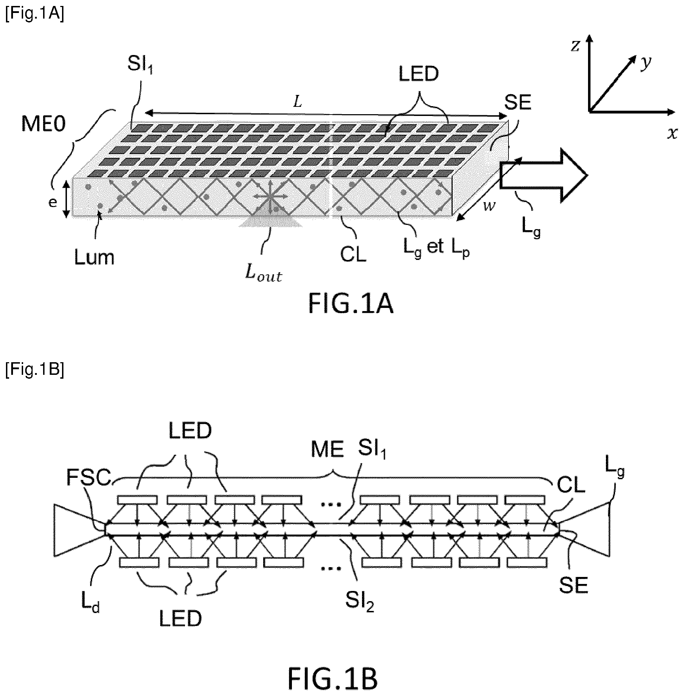

Les figures 1A et 1B illustrent un exemple de module d'émission de lumière ME0 connu de l'art antérieur basé sur un cristal concentrateur CL. Les figures 1A et 1B représentent, de façon schématique, des vue respectivement en perspective et de côté d'un même module d'émission ME0. Le module d'émission ME0 comprend un ensemble de LED destinées à émettre dans une première bande spectrale et un concentrateur de lumière CL. Le concentrateur CL est un cristal parallélépipédique fluorescent, présentant au moins une face d'éclairement SI1, SI2, de dimensions $L \times w$, illuminée par le rayonnement électroluminescent $L_d$ émis par les LED. On appelle aussi les faces d'éclairements SI1, SI2 « grandes faces ». L'épaisseur du concentrateur est notée e.
Le cristal du concentrateur est configuré pour absorber ledit rayonnement électroluminescent $L_d$. Le flux lumineux émis par les LED et dirigé vers la face d'éclairement est absorbé par les luminophores Lum du cristal fluorescent qui sont répartis dans l'ensemble du volume du cristal et qui émettent alors un rayonnement de fluorescence à l'intérieur du cristal. Les rayons émis peuvent être classés en deux grandes catégories :

- les rayons piégés notés $L_p$ : ces rayons sont piégés dans le cristal du fait de la réflexion totale interne (RTI) sur les différentes faces du cristal. Ces rayons existent si le cristal est un parallélépipède doté de 6 faces parallèles deux à deux et perpendiculaires entre elles. Les rayons piégés ne sortent jamais du cristal, aux imperfections près de ce dernier.

- les rayons non piégés sont les rayons qui finissent par sortir du cristal. Ils se séparent en deux sous-catégories : les rayons guidés notés $L_g$ dont la caractéristique est d'être guidés par RTI et de sortir sur l'une des faces du concentrateur et les rayons non guidés notés $L_{out}$ qui sortent directement du concentrateur sans se réfléchir sur les faces.

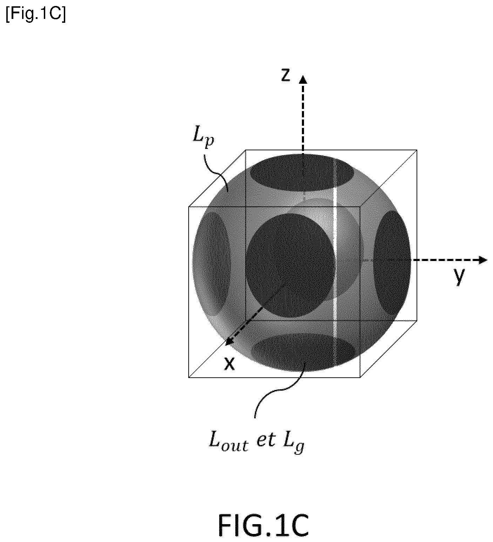

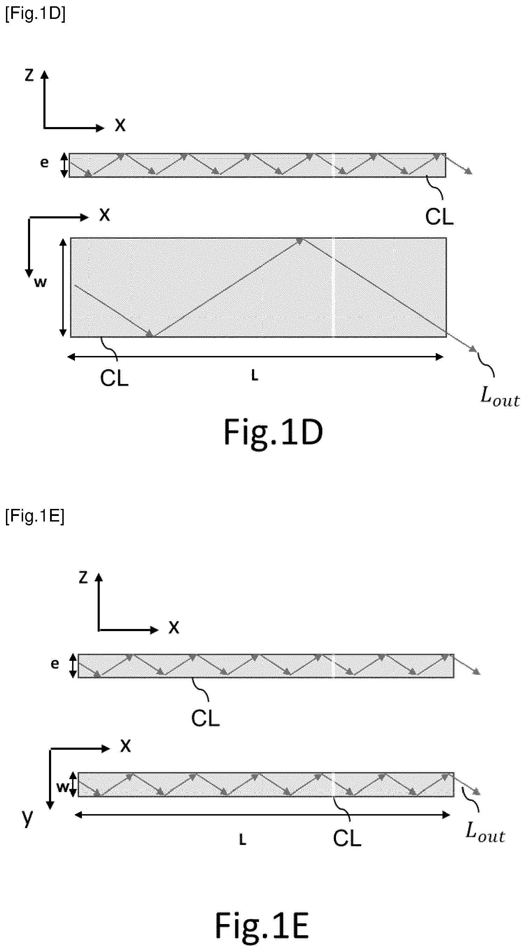

La figure 1C est une représentation du diagramme angulaire des rayons émis et piégés dans le concentrateur. Les calottes sombres représentent les angles correspondant aux rayons non piégés (guidés et non guidés) et les zones claires représentent les angles correspondant aux rayons piégés, Dans cette représentation donnée à titre d'exemple, le milieu choisi comme cristal concentrateur CL est un cristal de Ce:YAG (indice $n_2$=1,82) présentant un angle critique de 33° lorsque le milieu ambiant est l'air. Le pourcentage de rayonnement piégé par RTI par rapport au rayonnement non piégé est fixé par l'indice du cristal et celui du milieu ambiant par la loi de Snell-Descartes.
Dans un concentrateur de l'art antérieur, comme celui illustré dans les figures 1A à 1C, l'éclairement de la face de sortie est proportionnel au ratio L/e entre la longueur et l'épaisseur du cristal concentrateur. En général, les concentrateurs ont des rapports L/e très grands (par exemple L=100 mm, e=1 mm, L/e=100). Le nombre de réflexions sur les deux grandes faces $SI_1$ $SI_2$ est donc important : de l'ordre d'une centaine pour un rayon incliné de 20-30° se propageant dans L=100 mm. En revanche, il est beaucoup moins important sur les faces latérales. Les figures 1D et 1E comparent la différence en nombre de réflexions pour un rayon en limite de réflexion totale interne dans un cristal concentrateur d'indice n=1,82 (angle limite $\theta_{crit}$ = 33°) dans les deux plans : parallèle (*xy*) et perpendiculaire (*xz*) aux grandes faces. Dans le plan des grandes faces, (*xy*)*,* le nombre de réflexions est lié à la largeur w du concentrateur. La figure 1D représente un concentrateur présentant une largeur w>>e. Dans ce cas, l'effet de concentration se produit dans un seul plan (*xz*) perpendiculaire aux grandes faces : ce type de concentration est défini ici comme concentration "1D". La concentration "1D" est utilisé pour les concentrateurs luminescents de grande dimension dans le domaine du solaire (voir par exemple Meinardi, Francesco, et al. "Large-area luminescent solar concentrators based on 'Stokes-shift-engineered'nanocrystals in a mass-polymerized PMMA matrix." Nature Photonics 8.5 (2014): 392).
La figure 1E représente un concentrateur dont la largeur w est du même ordre de grandeur que l'épaisseur e. Dans ce cas, l'effet de concentration intervient dans les deux plans (xz) et (xy) : les réflexions sur les 4 faces latérales du concentrateur sont utilisées. Ce type de concentration est défini ici comme concentration "2D". Cette configuration est la plus souvent utilisée pour les concentrateurs pompés par LED (voir par exemple D. K. G. de Boer, D. Bruls, et H. Jagt "High-brightness source based on luminescent concentration" Optics Express, vol. 24, no. 14, page A1069, July 2016.). Un des inconvénients de cette concentration 2D est que les faces d'éclairement ont une surface réduite, ce qui limite la puissance de pompe du concentrateur et donc sa puissance de sortie.

Les concentrations "1D" et "2D" donnent la même luminance en sortie pour un matériau donné avec L et e fixé. En effet, la luminance ne dépend pas de w mais uniquement du ratio L/e.

Bien que l'augmentation d'éclairement à l'aide d'un concentrateur soit très significative par rapport à des LED, l'éclairement reste faible par rapport à l'éclairement fourni par des diodes lasers par exemple. De plus la forme du faisceau de sortie est tributaire de la géométrie du concentrateur (en général, la surface de sortie est elliptique). Enfin, dans les concentrateurs fluorescents de l'art antérieur, l'épaisseur e doit être supérieure à la longueur d'absorption liée au rayonnement de pompe afin que la puissance absorbée soit maximale. Dans un milieu de faible absorption dans une concentration "1D" ou "2D".

L'invention vise à augmenter la luminance en sortie d'un concentrateur tout en donnant de la souplesse sur les paramètres du faisceau de sortie et sur le cahier des charges concernant le matériau concentrateur (dimensions, pertes, absorption).

### Résumé de l'invention :

A cet effet, un objet de l'invention est un dispositif d'émission lumineuse tel que défini par la revendication 1.

Selon des modes particuliers de l'invention :

- le ratio R est inférieur ou égal à 1/8 ;

- l'élément déclencheur de luminescence comprend une pluralité de diodes électroluminescentes ou des lasers ou des lampes flash configurées pour émettre un rayonnement électroluminescent à une longueur d'onde $\lambda_d$, lesdites diodes étant agencées de manière à illuminer au moins une face dite d'éclairement du concentrateur, ledit concentrateur étant un cristal fluorescent adapté pour absorber ledit rayonnement électroluminescent puis émettre un rayonnement de fluorescence correspondant audit rayonnement de luminescence ;

- une dimension verticale e du concentrateur dans une direction z perpendiculaire à ladite face d'éclairement est supérieure ou égale à une longueur d'absorption $L_{abs}$ dudit rayonnement électroluminescent par ledit concentrateur ;

- l'élément déclencheur de luminescence comprend un élément chauffant configuré pour chauffer ledit cristal concentrateur pour qu'il émettre ledit rayonnement de luminescence par thermoluminescence ;

- l'élément déclencheur de luminescence comprend une lentille adaptée pour focaliser un rayonnement solaire sur une face dite d'éclairement du concentrateur, ledit concentrateur étant adapté pour absorber ledit rayonnement solaire puis émettre un rayonnement de fluorescence correspondant audit rayonnement de luminescence ;

- le cristal concentrateur présente une arête biseautée située entre la première face latérale et une autre face dudit cristal concentrateur, une surface de l'arête biseautée étant considérée comme faisant partie de la surface de la première face latérale pour le calcul dudit ratio R, au moins une portion d'une surface de l'arête biseautée n'étant pas recouverte et définissant une face de sortie associée ;

- le cristal concentrateur présente un coin biseauté situé entre la première face latérale et deux autres faces dudit cristal concentrateur, une surface du coin biseautée étant considérée comme faisant partie de la surface de la première face latérale pour le calcul dudit ratio R, au moins une portion de ladite surface du coin biseautée n'étant pas recouverte et définissant une face de sortie associée ;

- le premier miroir est adapté pour définir $n \geq 1$ surfaces non recouvertes, définissant n faces de sortie traversées par n faisceaux de sortie, ledit dispositif comprenant en outre :

    - n fibres optiques et

    - n systèmes optiques de couplage chacun adapté pour coupler un faisceau de sortie dans une fibre optique différente ;

- le premier miroir est adapté pour qu'une étendue géométrique de chaque faisceau de sortie soit sensiblement égale à une étendue géométrique de ladite fibre optique couplant ledit faisceau de sortie ;

- le dispositif comprend deux miroirs additionnels couvrant deux faces parallèles dites tranches du concentrateur, lesdits deux miroirs additionnels étant agencés de manière à couvrir la totalité des tranche ;

- le dispositif comprend un premier et un second module d'émission et un premier élément déclencheur de luminescence associé au premier module d'émission, une face du cristal concentrateur du second module d'émission différente d'une face latérale étant accolée à une face de sortie du cristal concentrateur dudit premier module d'émission, de manière à ce que le premier faisceau de sortie du premier module d'émission, dit rayonnement de luminescence primaire, constitue l'élément déclencheur de luminescence du deuxième module d'émission, le deuxième module d'émission générant un deuxième faisceau de sortie dit rayonnement de luminescence secondaire, présentant une longueur d'onde centrale décalée par rapport à une longueur d'onde centrale du rayonnement de luminescence primaire ;

- des dimensions du second module dans un plan vertical yz parallèle à ladite face de sortie du cristal concentrateur du premier module sont inférieures ou égales à des dimensions de ladite face de sortie du concentrateur du premier module d'émission ;

- une dimension du concentrateur du second module selon la direction *x* est supérieure à une longueur d'absorption $L_{abs,2}$ du rayonnement de luminescence primaire par le concentrateur du second module ;

- le premier miroir est monté sur un système de translation adapté pour déplacer ledit premier miroir relativement à ladite première face latérale de manière à réduire ou accroitre la surface non recouverte ;

- le premier miroir est adapté pour que la forme d'une surface non recouverte soit carré, rectangulaire, circulaire, elliptique, triangulaire ou encore polygonale

**Brève description des figures :**

D'autres caractéristiques, détails et avantages de l'invention ressortiront à la lecture de la description faite en référence aux dessins annexés donnés à titre d'exemple et qui représentent, respectivement :

[Fig.1A], [Fig.1B] et [Fig.1C], une vue schématique d'un exemple de module d'émission lumineuse connu de l'art antérieur,

[Fig.1D] et [Fig.1E], une vue schématique de concentrateurs connus de l'art antérieur,

[Fig.2] une vue schématique d'un dispositif d'émission lumineuse selon l'invention,

[Fig.3A] et [Fig.3B], une représentation schématique d'un trajet d'un rayon du rayonnement de fluorescence,

[Fig.4] deux courbes de transmission en fonction de l'angle de sortie des rayons du rayonnement de fluorescence,

[Fig.5A], la transmission moyennée en fonction de la dimension s de la face de sortie,

[Fig.5B], l'évolution du ratio $E/E_{ref}$ en fonction de la dimension s de la face de sortie,

[Fig.5C], l'évolution de la longueur moyenne en fonction de la dimension s de la face de sortie,

[Fig.6A] et [Fig.6B], respectivement, la transmission moyenne $T_{moy}$ et l'évolution du ratio $E/E_{ref}$ en fonction de la dimension s de la face de sortie pour différentes valeurs de coefficient de perte,

[Fig.7A] et [Fig.7B], une évolution du ratio $E/E_{ref}$ et du ratio $L_{moy}/L_p$ en fonction de la dimension s de la face de sortie pour deux valeurs coefficient de perte différente,

[Fig.8], un mode de réalisation de l'invention, dans lequel le cristal concentrateur est un cube,

[Fig.9], l'évolution de la puissance de sortie $P_{out}$ du faisceau de sortie et de l'éclairement $E$ en fonction de la surface de la face de sortie,

[Fig.10A] et [Fig.10B], dispositif selon des modes de réalisation de l'invention dans lesquels le premier miroir est adapté pour que la forme de la surface non recouverte soit respectivement un disque et d'une lettre « A »,

[Fig.11], un mode de réalisation dans lequel le cristal concentrateur présente une arête biseautée,

[Fig.12], un mode de réalisation dans lequel le premier miroir est monté sur un système de translation,

[Fig.13A], un mode de réalisation dans lequel plusieurs sorties fibrées se recombinent sous la forme d'un groupement de fibres,

[Fig.13B], une évolution de la puissance couplée $P_c$ dans une fibre optique en fonction de la surface de la face de sortie,

[Fig.14], un mode de réalisation de l'invention dans lequel le dispositif comprend un premier et un second module d'émission

Dans les figures, sauf contre-indication, les éléments ne sont pas à l'échelle.

### Description détaillée :

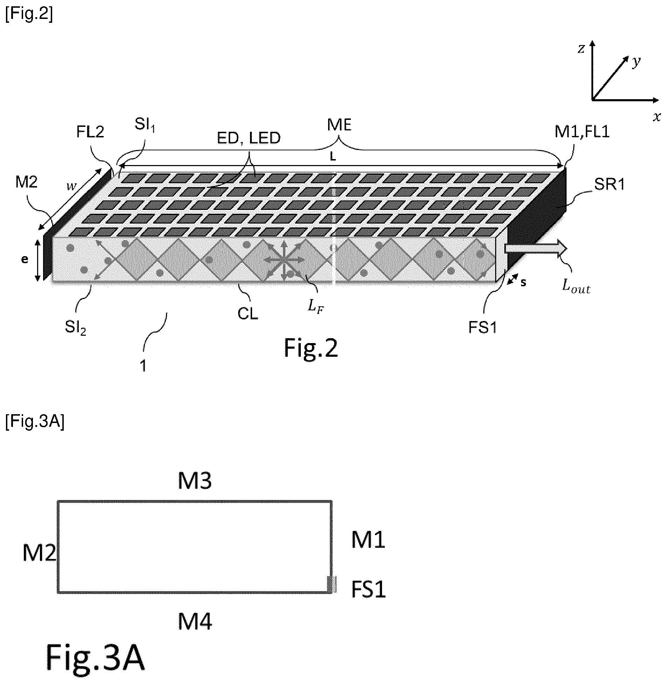

La figure 2 présente une vue schématique d'un dispositif d'émission lumineuse 1 selon l'invention. Le dispositif comprend un module d'émission ME comprenant un cristal luminescent dit concentrateur CL. Ce cristal concentrateur comprend six faces parallèles deux à deux, dont une première et une deuxième face dites latérales FL1, FL2, de dimensions $w \times e$. Ces faces latérales sont perpendiculaires à une direction $x$ et séparées d'une distance L (appelée longueur) correspondant à une dimension horizontale du concentrateur selon la direction x, L étant la plus grande des dimensions du concentrateur. On appelle « grandes faces » ou « faces d'éclairement », les faces $SI_1$ et $SI_2$ de dimensions $L \times w$ et on appelle « tranches » les faces de dimensions $L \times e$.

Le dispositif 1 comprend un élément déclencheur de luminescence ED adapté pour générer une émission d'un rayonnement de luminescence $L_F$ dans le cristal luminescent. Comme cela sera précisé plus loin, l'élément déclencheur de luminescence peut être une pluralité de LED, un ou plusieurs élément optique adaptés pour diriger le rayonnement solaire sur le concentrateur ou encore un élément adapté pour chauffer le concentrateur.

De manière différente des concentrateurs 1D et 2D évoqués précédemment, le but de l'invention est d'obtenir un effet de concentration dans une direction supplémentaire afin d'augmenter la luminance obtenue en sortie de concentrateur. On appelle cet effet concentration 3D car le rayonnement est concentré au sein du cristal sur toutes les faces de ce dernier. Pour cela, le dispositif 1 comprend deux miroirs M1 et M2 adaptés pour créer un effet de concentration supplémentaire dans le plan *(xy)* sur les faces latérales, en plus de l'effet de concentration obtenu dans le plan *(xz)* sur les grandes faces (et éventuellement dans le plan *(xy)* sur les tranches, en fonction de la largeur *w* du concentrateur). Ainsi, il est possible de multiplier les réflexions sur les faces latérales avant que les rayons du rayonnement de luminescence « sortent » du concentrateur, ce qui induit une augmentation de l'éclairement sur la face de sortie et de la luminance par effet de repli des rayons sur eux-mêmes.

Le premier miroir M1 est configuré de manière à couvrir partiellement la première face latérale FL1 définissant une surface recouverte SR1 par le premier miroir et au moins une surface non recouverte SFS1 par le premier miroir définissant une face de sortie associée FS1. Pour cela, le premier miroir M1 est disposé en regard de, accolé à ou déposé sur la première face latérale FL1. Après de nombreuses simulations et comme cela sera expliqué plus loin, les inventeurs ont réalisé que le ratio de la surface de la face de sortie par rapport à celle de la première face latérale était le paramètre critique permettant d'assurer un effet concentrateur sur les faces latérales et donc assurer une augmentation de l'éclairement sur la face de sortie. Les dimensions du module d'émission sont adaptées pour qu'un ratio $R = SFS1/S_L$ entre la surface non recouverte SFS1 (surface de la face de sortie FS1) et la surface totale de la première face latérale $S_L$ soit adapté de manière à ce que des rayons du rayonnement de luminescence se réfléchissent sur le premier et le deuxième miroir et se propagent en moyenne sur une distance moyenne $L_{moy} \gg L$ au sein du cristal CL avant de traverser une face de sortie FS1. Les rayons du rayonnement de luminescence sortant du concentrateur forment un faisceau de sortie $L_{out}$. Par $L_{moy} \gg L$, on entend ici que $L_{moy}$ est supérieur à 7 fois préférentiellement 15 fois L.

Comme cela sera détaillé plus loin, un ratio $R = SFS1/S_L$ adapté pour vérifier la condition $L_{moy} \gg L$ permet d'assurer que l'effet concentrateur dans le plan 3D existe, c'est-à-dire que le rayonnement luminescent, au lieu de traverser directement la face de sortie FS1 après avoir été généré, est majoritairement réfléchi au sein du cristal et réalise en moyenne plusieurs allers retours au sein du cristal avant de sortir par une face de sortie FS1. Plus le ratio $R = SFS1/S_L$ est petit, plus la distance moyenne $L_{moy}$ parcourue par les rayons de luminescence au sein du concentrateur avant de sortir augmente. Ainsi, l'éclairement sur la face de sortie est augmenté car le rayonnement de luminescence a le temps de « remplir » le concentrateur avant de sortir. Ce point est particulièrement contre-intuitif car on pourrait penser que le ratio des puissances de sortie avec et sans miroir M1 est simplement égal au ratio des surfaces $SFS1/S_L$ : ce serait le cas si tous les rayons étaient émis à partir d'un même plan. Ici l'effet de volume et de réflexions multiples à l'intérieur du volume permet d'avoir une puissance de sortie sur la face de sortie FS1 supérieure. De manière notable, les inventeurs ont remarqué que lorsque le ratio $R$ est inférieur ou égal à 1/4, ou de manière préférentielle, inférieur ou égal à 1/8 la distance moyenne $L_{moy}$ est suffisante pour que le module ME réalise un effet concentrateur conséquent (voir plus loin). Aussi, selon l'invention, le ratio $R$ est inférieur ou égal à 1/4, ou de manière préférentielle, inférieur ou égal à 1/8.

Le second miroir M2 est configuré de manière à couvrir au moins 99% de la deuxième face latérale FL2, opposée à la première face latérale. De manière préférentielle, le second miroir M2 couvre la totalité de la deuxième face latérale.

Ainsi, le rayonnement de luminescence ne peut sortir des faces latérales que par la face de sortie FS1. En effet, les miroirs M1, M2 forcent les rayons qui devraient sortir par les faces latérales à faire plus de trajet dans le concentrateur, jusqu'à traverser la surface non recouverte et donc la face de sortie FS1. Ce trajet implique qu'il existe des réflexions multiples au sein du concentrateur sur les faces latérales. Ainsi, l'éclairement du faisceau de sortie au niveau de la face de sortie est augmenté par l'utilisation des miroirs M1 et M2.

Dans l'illustration de la figure 2, à titre non limitatif, la face de sortie est rectangulaire et présente une dimension égale à l'épaisseur e du concentrateur selon la direction z et une dimension s selon la direction y. Aussi, la face de sortie est de dimension $s \times e$. Dans cet exemple, le ratio R est donc égal au ratio $s/w$. Alternativement, selon un autre mode de réalisation, le premier miroir est adapté pour que la forme de la surface non recouverte (et donc de la face de sortie) soit carré, rectangulaire, circulaire, elliptique, triangulaire ou encore polygonale.

Les miroirs M1 et M2 présentent un facteur de réflexion supérieur à 95%, préférentiellement supérieur à 98% pour le rayonnement de luminescence.

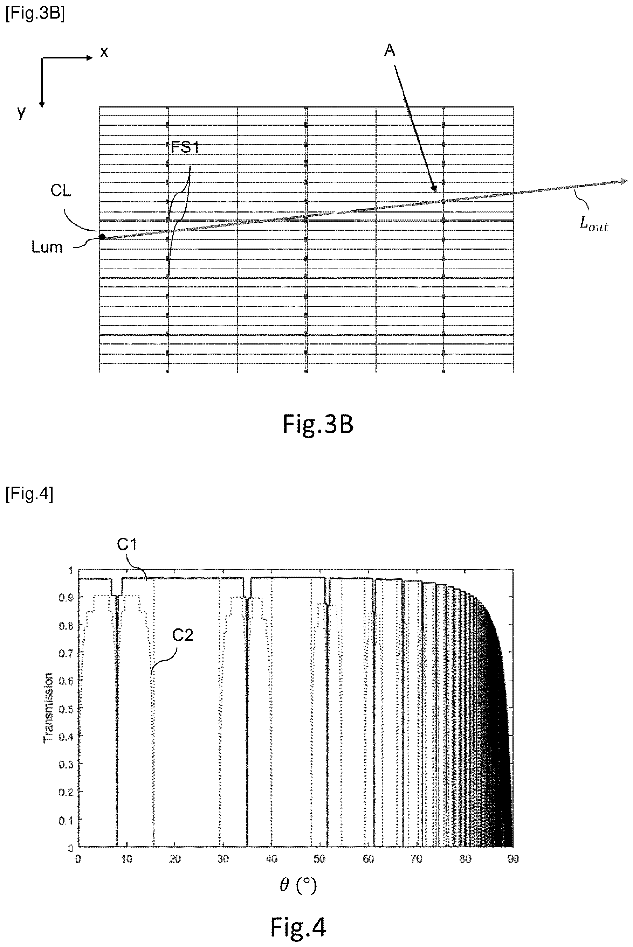

La figure 3B est une représentation schématique d'un trajet d'un rayon du rayonnement de fluorescence émis par un luminophore Lum dans le plan (xy) de la face d'éclairement $SI_1$ et du moment où il « sort » du concentrateur par la face de sortie FS1. Dans ce mode de réalisation, le dispositif comprend en outre deux miroirs additionnels M3, M4 (visibles dans la figure 3A) agencés en regard ou déposés sur les tranches du concentrateur. Les deux miroirs additionnels sont agencés de manière à couvrir la totalité des tranches. Ces miroirs permettent de réfléchir au sein du concentrateur la portion du rayonnement de luminescence non guidée par RTI et qui devraient sortir du concentrateur par les tranches et ainsi d'augmenter l'éclairement sur la face de sortie. Dans ce mode de réalisation et ceux des figures suivantes, le miroir M2 recouvre complétement la deuxième face latérale FL2 afin de maximiser l'éclairement sur la face de sortie. Alternativement, dans un autre mode de réalisation, le miroir M2 ne recouvre pas complétement la deuxième face latérale FL2.

Dans la représentation de la figure 3B, le concentrateur CL est déplié à chaque réflexion pour la clarté du dessin au lieu de tracer les réflexions multiples du rayon. Aussi, chaque rectangle unitaire (ou réplique) représente un concentrateur CL. Les plans étant tous parallèles deux à deux, le rayon équivalent correspondant au rayon réfléchi par le premier et second miroir se propage en ligne droite sur le dessin incluant le concentrateur et ses répliques par rapport aux 4 miroirs que constituent les faces latérales. La face de sortie FS1 est aussi représentée dans chaque réplique. Pour savoir si le rayon va effectivement sortir, il faut observer le point A où celui-ci intercepte une des répliques de la face de sortie. Dans l'exemple de la figure 3B, le rayon va finir par sortir au bout de 4 réflexions sur les tranches et 4 réflexions sur les faces latérales.

Chaque réplique de la zone de sortie correspond donc à un ensemble d'angles qui permet une sortie.

En sommant sur l'ensemble de ces angles et en tenant compte des pertes par propagation du rayonnement de luminescence dans le concentrateur CL, on peut estimer la transmission moyenne à partir d'un point source dans le concentrateur, sur une plage angulaire donnée.

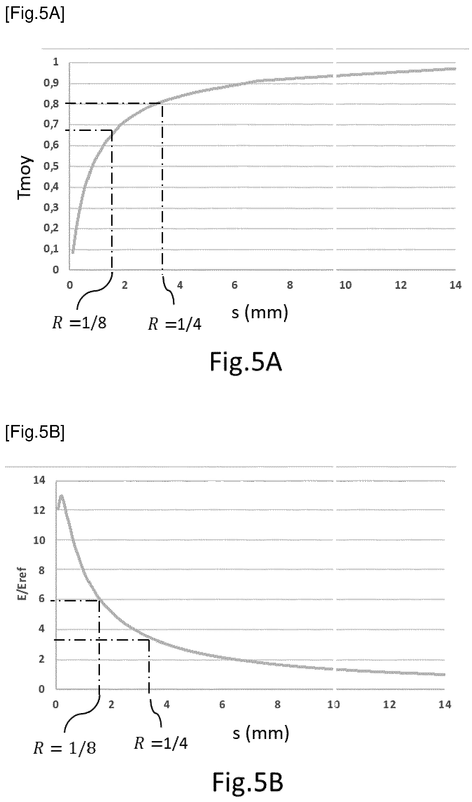

La figure 4 présente deux courbes de transmission C1, C2 en fonction de l'angle de sortie des rayons du rayonnement de fluorescence. L'angle de sortie $\theta$ est repéré par rapport à la normale de la face de sortie, dans le plan xy. Dans l'exemple de la figure 4, les dimensions du concentrateur sont les suivantes : L=100 mm, w=14 mm et e=1 mm. Ces dimensions sont données à titre d'exemple et ne sont pas limitatives. Dans ce mode de réalisation et ceux des figures 5A à 10, le premier miroir est adapté pour que la face de sortie soit rectangulaire et présente une dimension égale à l'épaisseur $e$ du concentrateur selon la direction z et une dimension s selon la direction y. Aussi, la face de sortie est de surface $SNR_1 = s \times e$. Dans ce cas précis, le ratio $R$ est donc égal à $s/w$. Alternativement, la face de sortie n'est pas rectangulaire. Les courbes C1 et C2 correspondent à un dispositif dans lequel, respectivement, $s = 7mm$; $R = 1/2$ et $s = 5mm$; $R \approx 1/3$.

On considère ici tous les rayons possibles, avec des incidences de rayons traversant la face de sortie allant jusqu'à 90°. Ce cas existerait si on collait le concentrateur à un milieu de sortie de même indice et si les faces latérales étaient parfaitement réfléchissantes pour toutes les incidences. Dans le cas où l'air est le milieu ambiant entourant le concentrateur, il faut considérer uniquement les rayons inférieurs à l'angle critique $\theta_{crit}$ = $\sin^{-1}(1/n)$ où n est l'indice du concentrateur. Dans le cas d'un concentrateur en Ce:YAG, n=1,82, ce qui correspond à un angle de sortie maximum de 33°.

Les courbes C1 et C2 comprennent des points de transmission très faible qui correspondent à des rayons avec des angles qui ne vont quasiment jamais traverser la face de sortie. Il faut noter que la transmission est très « piquée » autour de ces points. Par piqué, on entend ici que la pente de la courbe autour de ces points est très élevée. Lorsque la dimension de la face de sortie diminue (courbe C2), il existe un plus grand nombre d'angles (donc de rayons) correspondant à ces points de transmission faible. Par ailleurs, il faut noter que la transmission décroît globalement pour de fortes incidences : ceci est lié à l'augmentation de la distance moyenne de propagation $L_{moy}$ du rayonnement de luminescence dans la structure, avec de très nombreuses réflexions sur les faces latérales et donc de l'augmentation des pertes par propagation dans le milieu. Cet effet sera plus amplement décrit dans les figures 5A à 7B.

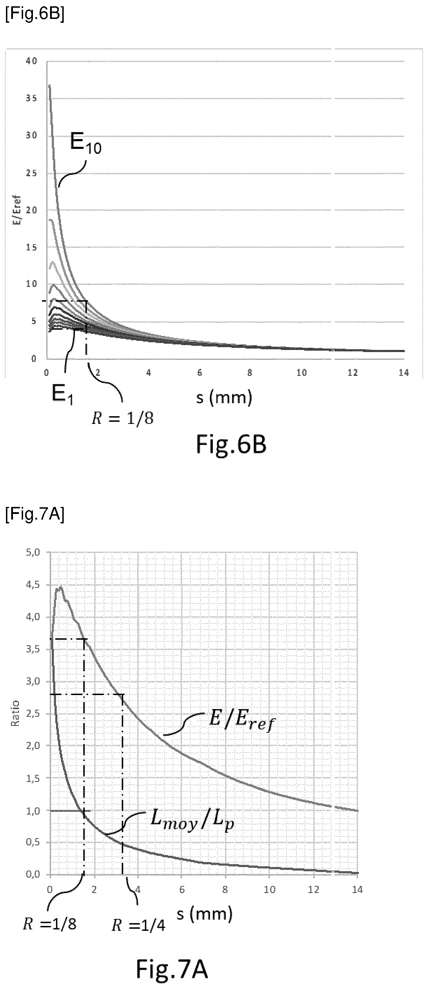

La figure 5A représente la transmission moyennée sur l'ensemble des rayons de luminescence traversant la face de sortie FS1 (voir figure 4), dans l'air, en fonction de la dimension $s$ de la face de sortie. Les dimensions sont identiques à celles de l'exemple de la figure 4. Dans ce cas précis, le ratio $R = SFS1/S_L$ est donc égal à $w/s$. Les courbes des figures 5A et 5B présentent donc une abscisse proportionnelle à R (cette remarque vaut pour les figures 7A à 8B et 10). Comme expliqué précédemment, les angles de sortie des rayons de luminescence sont compris entre 0 et 33°. La transmission moyenne Tmoy reste très élevée même pour de petites valeurs de s, grâce aux réflexions multiples dans le concentrateur. Ainsi, la transmission vaut encore 50% pour s=1mm (soit $R = 1/14$ ) et pour un coefficient de pertes $\alpha = 3.10^{-4}mm^{-1}$ (valeur classique pour un concentrateur en Ce:YAG). Pour une surface de face de sortie donnée, la longueur $L_{moy}$ est reliée à la transmission moyenne $T_{moy}$ et au coefficient de perte en $mm^{-1}$, $\alpha$, par la relation suivante : $L_{moy} = e^{-\alpha.Tmoy}$. $L_{moy}$ dépend uniquement des pertes $\alpha$ et de $T_{moy}$ qui dépend du ratio $R$. On définit la longueur correspondant aux pertes comme $L_p = 1/\alpha$.

La figure 5B représente l'évolution du ratio $E/E_{ref}$ entre l'éclairement $E$ sur la face de sortie obtenu avec un dispositif selon l'invention et l'éclairement $E_{ref}$ sur la première face latérale FL1 obtenu dans une configuration classique sans miroir M1 mais avec un miroir M2, en fonction de la dimension $s$ de la face de sortie. Les paramètres sont identiques à ceux de la figure 5A. La figure 5B permet d'observer que l'éclairement dans la zone de sortie augmente fortement dès que celle-ci a une surface suffisamment petite. Pour une valeur de R=1/4 (s=3.5mm), on note que l'éclairement sur la face de sortie augmente d'un facteur supérieur à 3. Pour une valeur de R=1/8 (s=1.75mm), on note que l'éclairement sur la face de sortie augmente d'un facteur 6. Ces valeurs correspondent à un effet concentrateur satisfaisant la concentration 3D permettant de gagner un ordre de grandeur (facteur 10) sur l'augmentation de l'éclairement. De manière notable, lorsque la face de sortie passe d'une dimension de $s = 14mm; R = 1$ à $s = 1mm; R = 1/14$, l'éclairement augmente d'un facteur 8. L'effet de concentration 3D tient dans la juxtaposition des effets illustrés par les figures 5A et 5B en trouvant un compromis: une transmission qui reste élevée malgré une forte réduction de la surface de la face de sortie et en conséquence un éclairement qui augmente. Pour des valeurs $s$ de la face de sortie très faibles, on note que l'éclairement sur la face de sortie diminue. Cet effet est dû à des pertes importantes par propagation du rayonnement de luminescence dans le concentrateur qui prédominent sur l'effet concentration 3D, ce qui donne une borne inférieure au ratio R pour un effet 3D optimal.

En faisant l'inventaire des rayons qui se réfléchissent sur M1 puis sur M2 à chaque passage et en tenant compte des rayons qui sortent à chaque impact sur la face FL1, il est possible de montrer que la longueur moyenne parcourue dans le milieu est

$$L_{moy} = \left(\frac{2}{R} - 1\right) \times L \ (eq1)$$

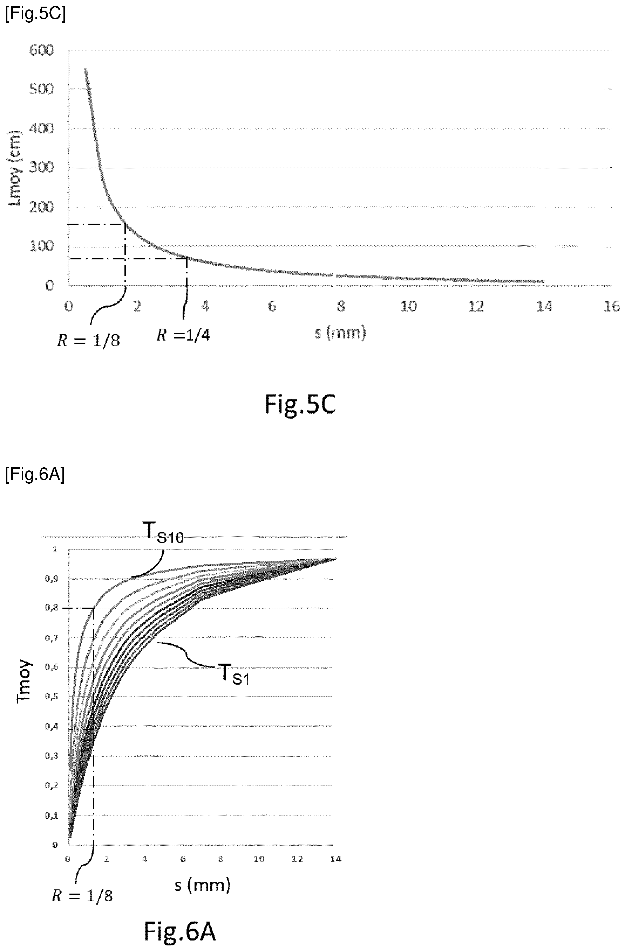

. La figure 5C illustre l'évolution de la longueur moyenne $L_{moy}$ en fonction de la dimension $s$ de la face de sortie. Les paramètres sont identiques à ceux de l'exemple de la figure 4. La courbe de la figure 5C est obtenue à partir de l'équation eq1 et permet de représenter l'impact direct du choix de la dimension s (et donc du ratio R) sur la longueur moyenne parcourue par un rayon de luminescence avant sa sortie du concentreur. On note que, pour un ratio R=1/4, $L_{moy}$ vaut environ 80cm, soit 7 fois plus que L et permet d'obtenir un accroissement de l'éclairement d'un facteur supérieur à 3 (voir figure 5B). Pour un ratio R=1/8, $L_{moy}$ vaut environ 160cm, soit 15 fois plus que L permettant d'obtenir un accroissement de l'éclairement d'un facteur 6.

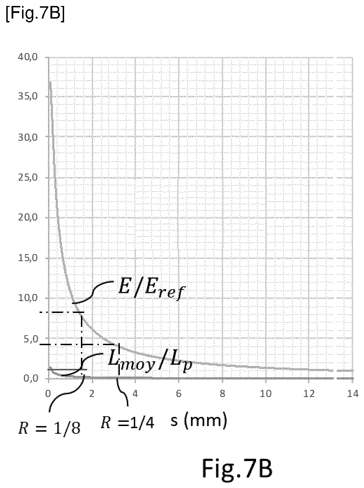

Les figures 6A et 6B représentent respectivement, la transmission moyenne $T_{moy}$ et l'évolution du ratio $E/E_{ref}$ en fonction de la dimension s de la face de sortie pour différentes valeurs de coefficient de perte (de $\alpha = 10^{-4}mm^{-1}$ pour les courbes $TS_{10}$ et $E_{10}$ à $\alpha = 10^{-3}mm^{-1}$ pour les courbes $TS_1$ et $E_1$). Les autres paramètres sont identiques à ceux de la figure 5A et de la figure 5B. On observe que l'augmentation des pertes a pour effet de réduire la transmission moyenne et l'éclairement sur la face de sortie (ratio $E/E_{ref}$). Cet effet est dû à l'augmentation des pertes par propagation (et la réduction de $L_p$) et est plus fort pour des surfaces de face de sortie faibles (R petit) car $L_{moy}$ est plus important. Pour une valeur de R=1/8 (s=1.75mm), on note que l'éclairement sur la face de sortie augmente d'un facteur allant de 4 à 8 lorsque les pertes passent de $\alpha = 10^{-4}mm^{-1}$ à $\alpha = 10^{-3}mm^{-1}$. Comme le montre la figure 6B, pour des pertes atteignant $10^{-3}mm^{-1}$ (courbe $E_1$), l'effet de concentration sur l'éclairement existe encore mais il semble "écrêté". Aussi, il est important que les dimensions du premier miroir soient adaptées aux pertes du concentrateur afin de garantir un effet de concentration 3D (voir figures 7A et 7B).

Les figures 7A et 7B représentent une évolution du ratio $E/E_{ref}$ et du ratio $L_{moy}/L_p$ en fonction de la dimension $s$ de la face de sortie pour un concentrateur présentant un coefficient de perte valant respectivement $\alpha = 10^{-3}mm^{-1}$ et $\alpha = 10^{-4}mm^{-1}$ soit respectivement $Lp = 1m$ et $Lp = 10m$ Lorsque $L_{moy}$ croit lorsque la surface de la face de sortie diminue. En effet, chaque rayon doit alors parcourir un chemin plus important avant de traverser la face de sortie. On note que pour des pertes élevées (figure 7A), $L_{moy}$ peut rapidement dépasser $L_p$ pour une surface de face sortie très faible (s inférieure à 1,6 mm). Lorsque s est très petit, , l'éclairement de la face de sortie (ratio $E/E_{ref}$) diminue lorsque s diminue du fait de pertes importantes par propagation dans le milieu. A l'inverse, pour une surface de face de sortie plus importante (pour s > 0,3mm sur la fig.7A), l'éclairement de la face de sortie (ratio $E/E_{ref}$) augmente lorsque s diminue. Pour une valeur R=1/4, l'éclairement augmente d'un facteur 2.75 par rapport à R=1 (s = 14 mm) et $L_{moy} = 0.5 \times L_p = 0.5m$. $L_{moy}$ est dans ce cas 5 fois plus élevé que L. Pour une valeur R=1/8, l'éclairement augmente d'un facteur 3.75 par rapport à R=1 et $L_{moy} = L_p = 1m$. $L_{moy}$ est donc 10 fois plus élevé que L.

Pour des pertes plus faibles (figure 7B), même lorsque s est très faible, l'éclairement de la face de sortie (ratio $E/E_{ref}$) continue de croître lorsque s diminue car $L_{moy}$ reste inférieur à $L_p$. Dans ce cas, les pertes ne prédominent pas sur l'effet concentrateur, même pour une face de sortie de petite surface. Pour une valeur R=1/4, l'éclairement augmente d'un facteur 4 par rapport à R=1. Pour une valeur R=1/8, l'éclairement augmente d'un facteur 8 par rapport à R=1. Dans les deux cas, $L_{moy}$

est très supérieur à L et reste inférieur à $L_p = 10m$.

Aussi, le ratio R est adapté par rapport aux pertes. On peut montrer que le ratio optimum vaut R=2αL. Aussi, selon un mode de réalisation préféré de l'invention, le ratio R vaut R=2αL pour avoir le plus grand ratio $E/E_{ref}$ possible..

Contrairement à la concentration 1D ou 2D, la concentration 3D n'est pas tributaire du facteur géométrique L/e. En effet, dans le dispositif de l'invention, l'éclairement sur la face de sortie est proportionnel à $\frac{S_L}{SFS1} e^{-Lmoy/L_p}$, avec $SFS1$, la surface de la face de sortie FS1 et $S_L$ la surface de la face latérale $SL1$. Cette caractéristique confère beaucoup plus de modularité au concentrateur 3D de l'invention comparativement au concentrateur 1D et 2D de l'art antérieur.

Selon un mode de réalisation, le concentrateur est un cristal fluorescent. Dans une première variante de ce mode de réalisation, de manière similaire aux dispositifs des figures 1A et 1B, l'élément déclencheur de luminescence comprend une pluralité de diodes électroluminescentes LED configurées pour émettre un rayonnement électroluminescent $L_d$ à une longueur d'onde $\lambda_d$. Dans ce mode de réalisation, les diodes sont agencées de manière à illuminer au moins une face d'éclairement SI1, SI2 du concentrateur. De plus, le cristal concentrateur est un cristal fluorescent, adapté pour absorber ledit rayonnement électroluminescent $L_d$ émis par les diodes LED puis émettre un rayonnement de fluorescence correspondant au rayonnement de luminescence $L_F$ évoqué plus haut. Alternativement, selon un autre mode de réalisation, l'élément déclencheur comprend des lasers ou des lampes flash adaptés pour pomper le cristal fluorescent.

De manière préférentielle, dans ce mode de réalisation, comme dans les concentrateurs de l'art antérieur, la dimension verticale e du concentrateur dans une direction $z$ perpendiculaire à la face d'éclairement (appelée épaisseur) est supérieure ou égale à une longueur d'absorption $L_{abs}$ du rayonnement électroluminescent $L_d$ par le concentrateur. Ainsi, le rayonnement émis par les LED est en grande majorité absorbé par le cristal concentrateur. Une épaisseur trop petite conduirait à une perte importante du rayonnement de pompe qui traverserait majoritairement le cristal sans être absorbé par ce dernier, et donc une baisse du rendement global optique/optique du concentrateur $P_{out}/P_{LED}$, avec $P_{out}$ la puissance du faisceau de sortie sur la face FL1 et $P_{LED}$ la puissance de pompe des LED.

Alternativement, selon une deuxième variante de ce mode de réalisation, l'élément déclencheur de luminescence comprend une lentille ou tout autre élément optique adapté pour focaliser ou diriger un rayonnement solaire sur une face d'éclairement SI1, SI2 du concentrateur. Dans ce mode de réalisation, le concentrateur est adapté pour absorber le rayonnement solaire puis émettre un rayonnement de fluorescence qui est le rayonnement de luminescence évoqué plus haut. Ce mode de réalisation permet de réduire le nombre de cellules photovoltaïques pour une surface de collection donnée. En effet, le dispositif de l'invention permet une bien meilleure concentration que les concentrateurs solaires conventionnels : la réduction de la surface couverte par les cellules photovoltaïques peut être d'un facteur 10 à 100.

De manière critique, le dispositif de l'invention permet de s'affranchir de la limitation des concentrateurs fluorescents de l'art antérieur concernant l'épaisseur du concentrateur, en lien avec l'absorption du rayonnement de pompe. En effet, dans un concentrateur fluorescent "1D" ou "2D", il y a deux options :

- soit réduire l'efficacité du concentrateur en conservant une épaisseur e petite et donc en sacrifiant l'absorption. Dans ce cas, la luminance peut rester importante.

- soit augmenter e pour augmenter l'absorption, et donc diminuer la luminance qui est proportionnelle au rapport L/e.

A l'inverse, dans le dispositif de l'invention, le premier miroir M1 permet de réduire « artificiellement » les dimensions de la face de sortie (et donc augmenter la luminance) sans diminuer l'épaisseur e (et donc sans sacrifier l'absorption du rayonnement de pompe). Cette caractéristique est particulièrement intéressante pour des concentrateurs CL émettant au-delà de 1 μm pour lesquels l'absorption est parfois faible. En effet, dans le cas de concentrateurs en verres dopés par exemple, la concentration des luminophores (et donc l'absorption) sera limitée par les interactions entre les ions du matériau (effet appelé "quenching" de fluorescence qui a pour effet de limiter les propriétés spectroscopiques d'émission). Le dispositif de l'invention permet ainsi d'utiliser des matériaux peu absorbants dans des concentrateurs efficaces dans l'infrarouge (jusqu'à 10 μm).

Alternativement, selon un autre mode de réalisation, le concentrateur est un cristal thermoluminescent et l'élément déclencheur de luminescence comprend un élément chauffant configuré pour chauffer ledit cristal concentrateur pour qu'il émettre le rayonnement de luminescence par thermoluminescence. Ce mode de réalisation permet d'utiliser des cristaux concentrateurs différents des cristaux fluorescents.

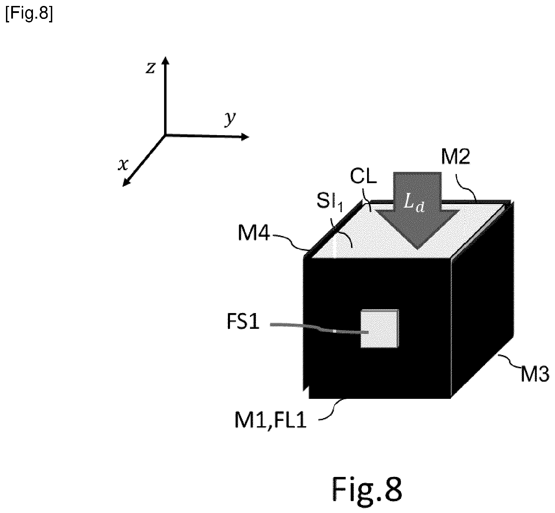

La figure 8 présente un mode de réalisation de l'invention, dans lequel le cristal concentrateur est un cube de dimension $a$. En effet, dans un concentrateur "3D", il n'y a pas de direction privilégiée quant au plan des grandes faces de pompage. Il est donc possible de choisir une géométrie adaptée pour le concentrateur qui permet de réduire l'encombrement : par exemple un cube. Dans le mode de réalisation de la figure 8, le concentrateur est un cristal fluorescent pompé par un rayonnement $L_d$ par une face d'éclairement $SI_1$. La dimension $a$ du cube concentrateur est supérieure à la longueur d'absorption $L_{abs}$ du rayonnement de pompe $L_d$ par le concentrateur. Dans ce mode de réalisation, le dispositif comprend, en plus des miroirs M1 et M2 sur les faces latérales FL1 et FL2, deux miroirs additionnels M3, M4 couvrant les faces parallèles au plan (*xz*). Ces miroirs additionnels permettent d'accroitre l'éclairement sur la face de sortie FS1 en réfléchissant, au sein du concentrateur, le rayonnement de luminescence non piégé par RTI qui devrait sortir par les faces recouvertes par les miroirs M3 et M4.

Dans le mode de réalisation de la figure 8, le premier miroir M1 est adapté pour que la surface non recouverte définisse une face de sortie carrée de dimension *b* inférieure à *a*. Ainsi, en réduisant les dimensions de la face de sortie on peut augmenter la luminance sans diminuer la dimension du cube et donc sans sacrifier l'absorption du rayonnement de pompe.

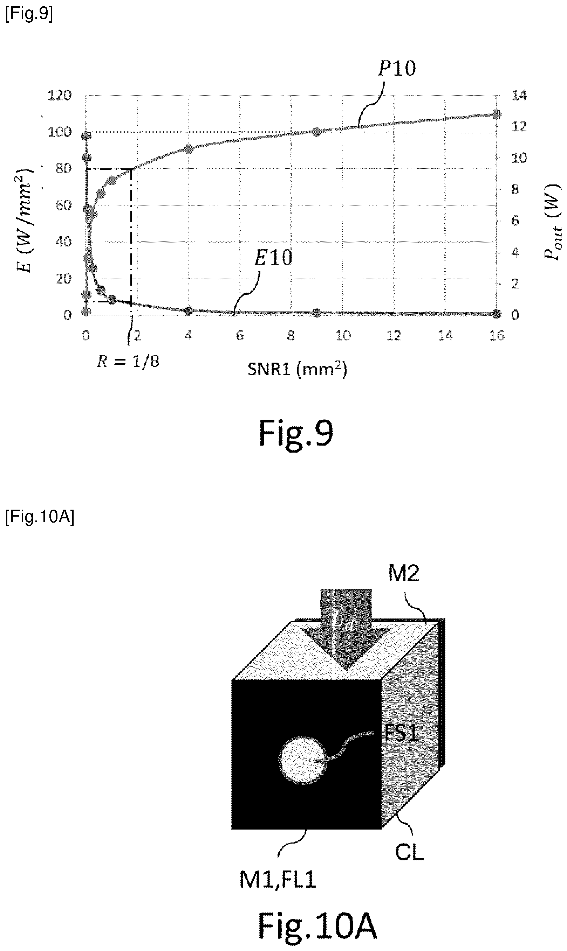

La figure 9 représente le résultat d'une simulation par un logiciel de tracés de rayons pour un dispositif identique à celui représenté en figure 8 et pour un concentrateur fluorescent cubique de 4 mm de côté éclairé par un rayonnement de pompe de puissance $P_{LED}$ = 40 W. La simulation donne l'évolution (courbe P10) de la puissance de sortie $P_{out}$ du faisceau de sortie et de l'éclairement $E$ (courbe E10) en fonction de la surface SFS1 de la face de sortie FS1. Comme vu précédemment, il est possible d'augmenter fortement l'éclairement tout en maintenant une puissance de sortie importante. La puissance de sortie $P_{out}$ est directement reliée à la transmission $T_{moy}$ (et donc au ratio R) et à la puissance du faisceau de sortie $P_{out,SM}$ qui sortirait de la première face latérale s'il n'existait pas de premier miroir M1 par la relation $P_{out} = T_{moy} * P_{out,SM}$. Quand R diminue, la transmission $T_{moy}$ diminue et donc la puissance de sortie aussi. Ainsi, pour un ratio R=1/8, l'éclairement vaut $E = 10W/mm^2$ alors que la puissance du faisceau de sortie vaut environ 9 W.

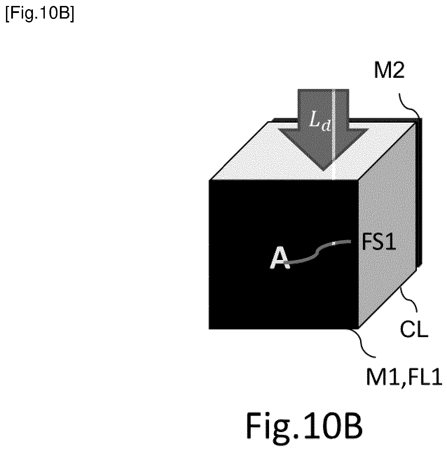

Les figures 10A et 10B représentent un dispositif selon des modes de réalisation de l'invention dans lesquels le premier miroir M1 est adapté pour que la forme de la surface non recouverte soit respectivement un disque et d'une lettre « A ». Il est entendu que la position de ces faces de sorties FS1 dans à la face latérale FL1 est libre. Les faces de sorties peuvent être dans des coins, au centre, accolé à une arête ou non. Ces figures illustrent la modularité du dispositif concentrateur 3D concernant la forme de la face de sortie. Contrairement à des filtres ou des caches utilisés couramment en projection, l'éclairement de sortie augmentera si la surface du motif à projeter diminue. Cette propriété très particulière permet de réaliser des affichages performants à fort éclairement.

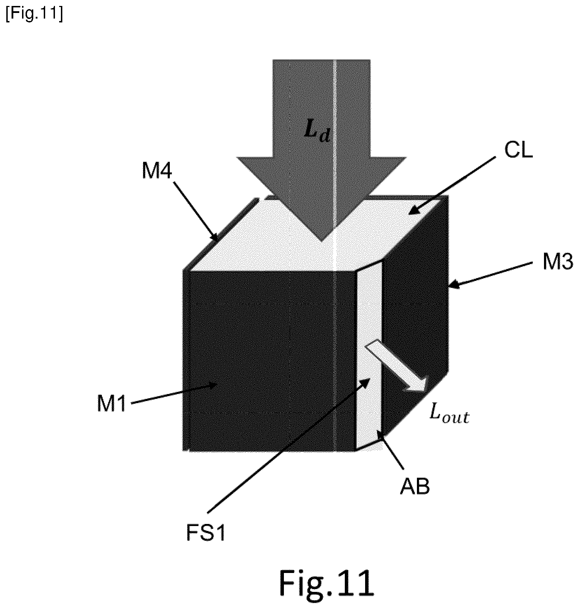

La figure 11 illustre un mode de réalisation dans lequel le cristal concentrateur présente une arête biseautée AB. L'arête biseautée est considérée comme faisant partie de la première face latérale. Plus précisément, l'arête biseautée AB est située entre la première face latérale et une autre face du cristal concentrateur. Cette face peut être n'importe quelle face adjacente à la première face latérale. Dans le mode de réalisation de la figure 11, l'arête biseautée AB n'est pas recouverte d'un miroir réfléchissant le rayonnement de luminescence. Ainsi, l'arête AB définit dans sa totalité une face de sortie FS1.

Alternativement, selon un autre mode de réalisation, seulement une portion d'une surface de l'arête biseautée n'est pas recouverte d'un miroir réfléchissant, cette portion définissant une face de sortie FS1. Ce mode de réalisation permet de réduire la surface de la face de sortie et donc d'augmenter l'éclairement.

Dans le calcul du ratio R = $SFS1/S_L$, la surface $S_L$ comprend la surface de l'arête biseauté et la surface non recouverte $SNR_1$ comprend la surface de la portion de l'arête biseautée non recouverte par un miroir (ou l'arête AB dans sa totalité si elle n'est pas recouverte d'un miroir).

Le mode de réalisation de la figure 11 permet d'augmenter l'éclairement de la face de sortie de 10% à 30% comparativement aux modes de réalisation de l'invention avec des concentrateurs symétriques (avec seulement 6 faces parallèles deux à deux) évoqués précédemment. En effet, en créant une arête biseautée sur le concentrateur, on crée une rupture de symétrie dans la structure parallélépipédique. Plus précisément, l'arête biseautée crée artificiellement un cône ou une zone d'échappement supplémentaire pour certains rayons de luminescence piégés par RTI au sein du concentrateur parallélépipédique qui peuvent sortir du concentrateur par le biais de l'arête. Sans l'arête biseautée AB, ces rayons ne pourraient pas sortir du cristal concentrateur.

Alternativement, selon un autre mode de réalisation, le cristal concentrateur présente un coin biseauté situé entre une première face latérale et deux autres faces du concentrateur. Tout comme le mode de réalisation de la figure 11, le coin biseauté est considérée comme faisant partie de la première face latérale et le coin peut être partiellement recouvert d'un miroir ou non. Ce mode de réalisation permet lui aussi d'augmenter l'éclairement de la face de sortie comparativement aux modes de réalisation de l'invention avec des concentrateurs symétriques évoqués précédemment.

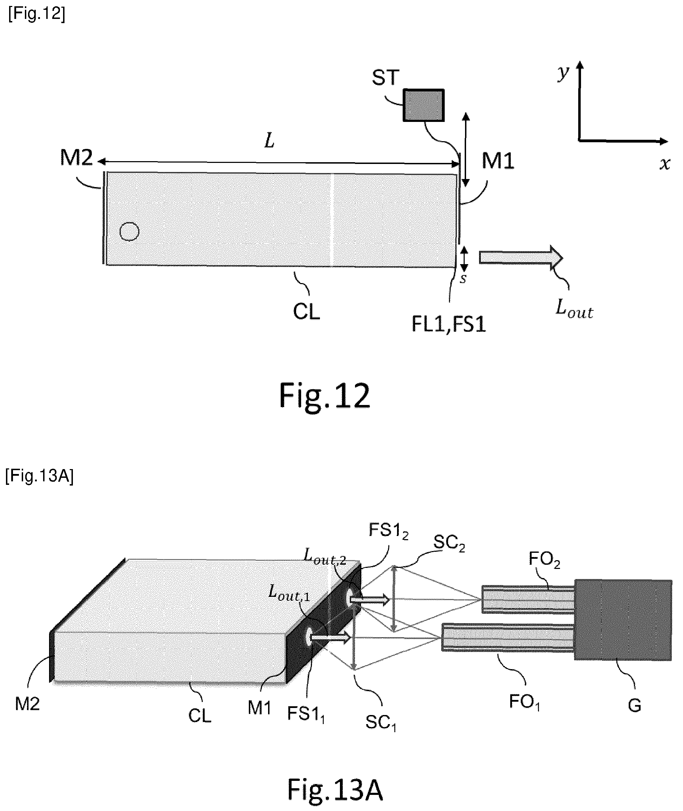

La figure 12 illustre un mode de réalisation dans lequel le premier miroir M1 est monté sur un système de translation ST adapté pour se déplacer relativement à la première face latérale FL1 de manière à réduire ou accroitre la surface non recouverte SFS1 de la face de sortie FS1. Dans l'exemple de la figure 12, le premier miroir est adapté pour définir une face de sortie rectangulaire de dimension $s \times e$, avec e l'épaisseur du concentrateur. Le système de translation permet de contrôler la dimension s afin d'accroître ou diminuer l'éclairement E sur la face de sortie FS1. Ce mode de réalisation permet de contrôler l'éclairement en sortie de module d'émission EM

Le dispositif de l'invention permet l'utilisation de plusieurs faces de sorties $FS1_i$ car la puissance du

faisceau de sortie $L_{out}$ est faible par rapport à la puissance circulant à l'intérieur du concentrateur. La figure 13A illustre un mode de réalisation dans lequel plusieurs sorties fibrées $FO1_i$ se recombinent sous la forme d'un groupement G de fibres. Dans ce cas, la luminance à la sortie du groupement G serait un peu plus faible que la luminance à la sortie d'une fibre seule, du fait de la difficulté à rapprocher tous les coeurs de fibre les uns des autres. En revanche, la puissance du rayonnement issue du groupement G sera fortement augmentée, et le rendement global aussi. Dans le mode de réalisation de la figure 13A, le premier miroir M1 est adapté pour définir $n \geq 1$ surfaces non recouvertes, définissant n faces de sortie $FS1_i$ traversées par n faisceaux de sortie $L_{out,i}$. Le dispositif comprend en outre *n* fibres optique $FO_i$ et *n* systèmes optiques de couplage $SC_i$ chacun adapté pour coupler un faisceau de sortie dans une fibre optique différente. Les systèmes optiques de couplage peuvent par exemple être une ou plusieurs lentilles optiques. Pour le calcul du ratio $R = SFS1/S_L$, la surface de la face de sortie $S_s$ est égale à la somme de la surface de toutes les faces de sorties $FS1_i$. Dans la représentation de la figure 13A, à titre non limitatif, $n = 2$. Alternativement, selon un autre mode de réalisation, un nombre différent de $n = 2$ est utilisé.

L'utilisation d'une sortie fibrée permet de simplifier le transport du faisceau de sortie vers son application. L'utilisation d'une sortie fibrée dans le dispositif de l'invention est grandement simplifiée compte tenu de la modularité de la face de sortie qui permet d'adapter la dimension de la face de sortie à celle du coeur de la fibre optique. Cela permet d'assurer un bon couplage du faisceau de sortie $L_{out,i}$ associée à la face de sortie $FS1_i$ dans la fibre optique $FO_i$ associée. Pour cela, il faut adapter l'étendue géométrique de chaque faisceau de sortie $L_{out,i}$. On rappelle que l'étendue géométrique est le produit de la surface de la zone émettrice par l'angle solide du faisceau émis.

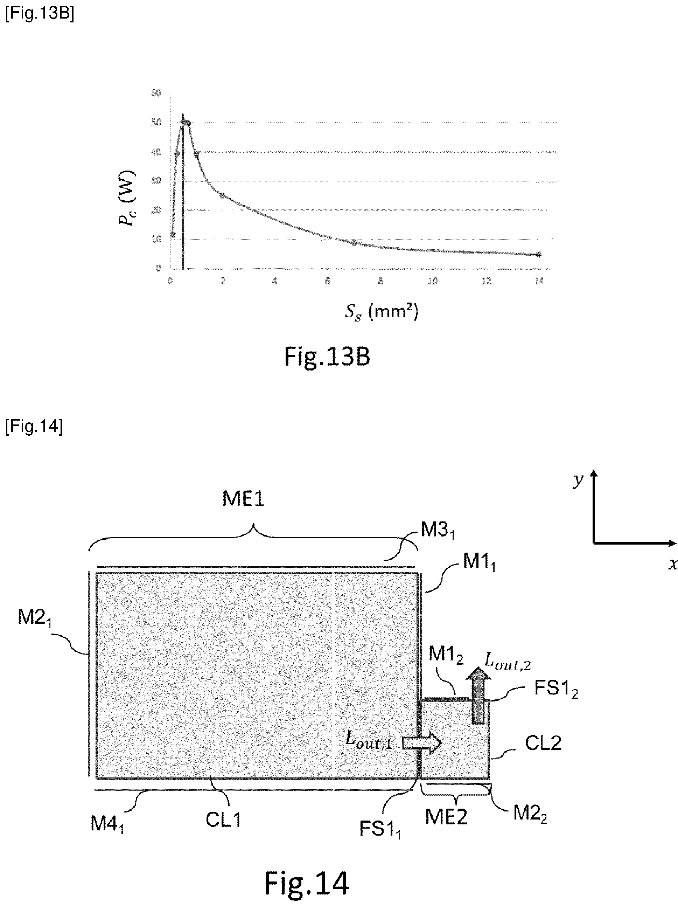

La figure 13B illustre l'évolution de la puissance couplée $P_c$ dans une fibre optique en fonction de la surface de la face de sortie (et donc de l'étendue géométrique). A titre non limitatif, la fibre possède une ouverture numérique de 0.5 et un diamètre de coeur de 1.5mm, donnant une étendue géométrique $Et_{fibre}=1,5 \ 10^{-2}$ $cm^2$.sr (pour cette simulation $n = 1$). Le concentrateur est une plaque en Ce :YAG de dimensions $L = 100mm$; $w = 14mm$; $e = 1mm$ et la puissance du faisceau de sortie par la face de sortie vaut $P_{out} = 50W$. On suppose de plus que l'émission du concentrateur est lambertienne. La puissance $P_c$ couplée dans la fibre est reliée à la puissance du faisceau de sortie $P_{out}$, à l'étendue géométrique de la fibre ($Et_{fibre}$) et celle du faisceau sur la face de sortie ($Et_c$) par la relation suivante : $P_c= (Et_{fibre}/Et_c).P_{out..}$

Comme le montre la figure 13B, la puissance couplée passe par un maximum, pour une surface de face de sortie $S_s = 380\mu m$, qui correspond dans ce cas spécifique à l'égalité des étendues. Pour des faces de sorties de surface inférieure, toute la puissance émise par le concentrateur peut être couplée (puisque $Et_{conc}<Et_{fibre}$) et c'est la transmission du concentrateur 3D qui limite les performances ($P_{out}$ diminue). Pour les faces de sorties de surfaces supérieures, c'est la transmission du système optique de couplage qui limite les performances du fait de l'inadéquation des étendues géométriques. Ainsi, de manière préférentielle, le premier miroir est adapté pour que l'étendue géométrique de chaque faisceau de sortie soit égale à une étendue géométrique de la fibre optique couplant le faisceau de sortie. Ce mode de réalisation est adapté pour les applications dans lesquelles la directivité de l'éclairement doit être contrôlé ou adaptée.

La figure 14 présente un mode de réalisation de l'invention dans lequel le dispositif comprend un premier et un second module d'émission ME1, ME2. Ces modules sont agencés de manière à ce que le concentrateur CL1 (dit premier concentrateur) du premier module pompe transversalement le concentrateur CL2 du deuxième module d'émission ME2 (dit second concentrateur). Le dispositif de la figure 14 comprend un premier élément déclencheur de luminescence (non représenté en figure 14) associé au premier module d'émission ME1. Comme vu précédemment, cet élément peut être une pluralité de LED, un ou plusieurs élément optique adaptés pour diriger le rayonnement solaire sur le premier concentrateur, ou encore un élément adapté pour chauffer ce concentrateur.

Une face du second concentrateur CL2, différente d'une face latérale $FL1_2$ où est située une deuxième face de sortie $FS1_2$, est accolée à la face de sortie $FS1_1$ du premier concentrateur CL1. De cette manière, le premier faisceau de sortie $L_{out,1}$ issu du premier module d'émission constitue l'élément déclencheur de luminescence du deuxième module d'émission ME2. Le deuxième concentrateur CL2 est adapté pour absorber le premier faisceau de sortie puis générer un deuxième faisceau de sortie $L_{out,2}$ dit rayonnement de luminescence secondaire, présentant une longueur d'onde centrale $\lambda_2$ décalée par rapport à la longueur d'onde centrale $\lambda_1$ du premier faisceau de sortie. Ce dispositif permet de générer un rayonnement intense car les effets de concentration sont cumulatifs sur la luminance.

De manière notable, les dimensions du second concentrateur dépendent uniquement des dimensions de la face de sortie $FS1_1$ du premier concentrateur CL1. Aussi, de manière préférentielle, les dimensions de la face du second module dans un plan parallèle à la face de sortie $FS1_1$ (plan *yz*) du premier concentrateur sont inférieures ou égales aux dimensions de la face de sortie $FS1_1$ du premier concentrateur.

Ce point est très important car la réduction de la taille du second concentrateur CL2, implique la réduction de la longueur moyenne parcourue à l'intérieur de ce concentrateur. $L_{moy}$ peut alors devenir très inférieure à $L_p$, ce qui a pour effet d'augmenter la transmission moyenne (voir figures 8A et 8B). Ceci permet d'utiliser pour CL2 des matériaux présentant des pertes plus élevées que celles de CL1.

Afin d'assurer une bonne absorption du premier faisceau de sortie dans le second concentrateur CL2, la largeur du second concentrateur est supérieure à une longueur d'absorption $L_{abs,2}$ du premier faisceau par le second concentrateur. Par largeur du second concentrateur, on entend ici la dimension du second concentrateur selon la direction de la longueur du premier concentrateur, c'est-à-dire selon la direction x.

A titre d'example non limitatif, le premier concentrateur (de dimensions $L_2$ = *100mm*; $w_2$ = 50mm; $e_2$ = 1*mm*) est en Ce :LYSO dont une première bande d'absorption se situe dans l'UV, vers 360 nm et le premier élément déclencheur comprend des LED UV émettant dans la première bande d'absorption une puissance de l'ordre de 1W/mm$^2$ en continu et 2,5W/mm$^2$ en régime impulsionnel. Le premier concentrateur émet un premier faisceau de sortie $L_{out,1}$ à une longueur d'onde centrale $\lambda_1$ = 430*nm* . Le second concentrateur (de dimensions $L_2$ = *10mm*; $w_2$ = 0.5*mm*; $e_2$ = 0.25*mm*) est en Ce :YAG et possède une seconde bande d'absorption présentant un recouvrement avec le spectre du premier faisceau de sortie et émet un deuxième faisceau de sortie centré en $\lambda_2$ = 560*nm*.

Compte tenu de la technologie actuelle des LED UV (avec un taux de remplissage de 16%), il est possible de mettre 800 LED sur chaque grande face du premier concentrateur CL1. On suppose que chaque LED fonctionne en régime impulsionnel et émet une puissance de 2.5W. La puissance de pompe vaut donc $P_{LED}$ = 4000*W.* La puissance émise par le premier module d'émission ME1 est alors de 550 W (en régime impulsionnel) sur sa première face latérale FL1$_1$ et un éclairement de 11*W*/mm$^2$. Ces valeurs ne tiennent pas compte de l'effet concentrateur 3D provoqué par les miroirs M1$_1$ et M2$_1$. Avec une première face de sortie FS$_1$ du premier concentrateur de forme rectangulaire et de dimension 0.25*mm* × 10 *mm,* l'effet de concentration 3D donne un éclairement sur la première face de sortie FS1$_1$ estimé à 28 W/mm$^2$.

Compte-tenu de la taille du second concentrateur et de la surface de FS1$_2$, et en supposant des pertes de $\alpha_{1,2}$=3.10$^{-4}$ mm$^{-1}$ , la transmission moyenne pour CL2 vaut 86%

Des simulations à l'aide d'un logiciel de tracé de rayons permettent d'estimer la puissance émise par le second concentrateur lorsqu'il est pompé par le premier concentrateur. Le rendement de conversion est calculé à 9,6% en tenant compte du recouvrement des bandes d'absorption et d'émission entre le premier et le second concentrateur. Le second concentrateur en Ce:YAG émet donc une puissance de 34 W sur sa première face latérale FL1$_2$. Cette mesure ne tient pas compte de l'effet concentrateur 3D provoqué par les miroirs M1$_2$ et M2$_2$. Avec une surface de la deuxième face de sortie FS1$_2$ rectangulaire de petite dimension 25$\mu m$ × 250 $\mu m$, l'effet de concentration 3D donne un éclairement sur la deuxième face de sortie FS$_2$ estimé à 4660W/mm$^2$, c'est à dire 466kW/cm$^2$. Cette valeur représente un éclairement plus de 1800 fois supérieur à celui des LED pompant le premier concentrateur. La puissance $P_{out,2}$ du deuxième faisceau de sortie vaut $P_{out,2}$ = 29 *W.*

On a choisi une surface de la deuxième face de sortie FS$_2$ sortie très faible car les dimensions du second concentrateur sont très petites par rapport à la longueur de perte $L_{p,2}$ du second concentrateur ($L_{p,2}$=3,3m avec $\alpha_2$=3.10$^{-4}$mm$^{-1}$). L'effet de concentration 3D peut donc être très performant dans le second concentrateur. Ainsi, la transmission moyenne reste à une valeur de 86% alors que la surface de la deuxième face de sortie FS1$_2$ est 10 fois plus faible que la surface de la face latérale FL1$_2$ du second concentrateur.

Le coefficient de concentration de cette cascade de concentrateurs 3D est donc de deux ordres de grandeur plus grand que celui donné par un seul concentrateur 1D ou 2D. Cette augmentation considérable se fait au prix d'un faible rendement global optique/optique $P_{out,2}$/$P_{LED}$, ici de 0,7%.

Cependant, pour réaliser un tel éclairement avec des lasers dans cette plage de longueurs d'onde, il faudrait réaliser une chaine de conversion complexe avec des cristaux non linéaires (aucun cristal laser n'émet directement dans le jaune orange). Le rendement optique/optique global serait au maximum de quelques pourcents. La source proposée ici est beaucoup plus simple, avec un éclairement qui devient compétitif par rapport aux lasers.

Il faut noter que l'exemple pris ici avec le Ce:LYSO et le Ce:YAG est loin d'être optimisé car le taux de remplissage des LED UV n'est que de 16% alors que celui des LED visibles est actuellement de 40% avec un potentiel pour atteindre 70% dans les années qui viennent.

La cascade de concentrateurs pourrait être très intéressante pour une émission dans l'infrarouge, dans la bande 3-5$\mu$m. Aussi, selon un autre mode de réalisation, le premier élément déclencheur comprend des LED visibles ou infrarouge (940 nm) dont le taux de remplissage est supérieur à 40%. Le second concentrateur est en verres sulfides ou selenide dont les pertes sont relativement élevées à l'heure actuelle. Comme vu plus haut, l'utilisation d'un concentrateur de petite taille permet de contourner le problème des pertes élevées.

Ainsi, la cascade de concentrateurs 3D selon le mode de réalisation de la figure 14 permet une grande souplesse pour s'adapter aux matériaux existant et à leurs propriétés. Ils représentent une rupture très importante dans le domaine des sources incohérentes, deux à trois ordres de grandeur au dessus de ce qui existe actuellement.

**Revendications**

**1.** Dispositif (1) d'émission lumineuse comprenant :

- au moins un module d'émission (ME) comprenant :

- un cristal luminescent dit cristal concentrateur (CL) présentant au moins six faces parallèles deux à deux, dont une première et une deuxième face dites latérales (FL1, FL2) perpendiculaires à une direction x et séparées d'une distance L correspondant à une dimension horizontale dudit concentrateur selon la direction *x*;
- un premier miroir (M1) configuré de manière à couvrir partiellement ladite première face latérale (FL1), définissant une surface recouverte (SR1) par ledit premier miroir et au moins une surface non recouverte (SFS1) par ledit premier miroir définissant une face de sortie associée (FS1, FS1$_1$, FS1$_2$),
- un second miroir (M2) configuré de manière à couvrir au moins 95% de ladite deuxième face latérale (FL2),

- un élément déclencheur de luminescence (ED) adapté pour générer une émission d'un rayonnement de luminescence ( $L_F$ ) dans ledit cristal luminescent ;

un ratio R entre la surface non recouverte (SFS1) et la surface totale ($S_L$) de la première face latérale (FL1) étant déterminé de sorte que des rayons du rayonnement de luminescence se réfléchissent sur lesdits premier et deuxième miroirs et se propagent sur une distance moyenne $L_{moy}$ telle que

$$L_p = \frac{1}{\alpha} > \quad L_{moy} \gg L$$ au sein du cristal luminescent avant de traverser au moins une face de sortie (FS1$_1$, FS1$_2$), formant un faisceau de sortie ($L_{out}$), ledit ratio R étant inférieur ou égal à 1/4, avec $\alpha$ le coefficient de perte par unité de longueur dudit concentrateur pour ledit rayonnement de luminescence défini comme le coefficient d'atténuation linéique de facteur e.

2. Dispositif selon la revendication 1, dans lequel ledit ratio R est inférieur ou égal à 1/8.

3. Dispositif selon l'une quelconque des revendication 1 à 2, dans lequel l'élément déclencheur de luminescence comprend une pluralité de diodes électroluminescentes (LED) ou des lasers ou des lampes flash configurées pour émettre un rayonnement électroluminescent ($L_d$) à une longueur d'onde $\lambda_d$, lesdites diodes étant agencées de manière à illuminer au moins une face dite d'éclairement (SI1, SI2) du concentrateur, ledit concentrateur étant un cristal fluorescent adapté pour absorber ledit rayonnement électroluminescent ($L_d$) puis émettre un rayonnement de fluorescence correspondant audit rayonnement de luminescence.

4. Dispositif selon la revendication 3, dans lequel une dimension verticale e du concentrateur dans une direction *z* perpendiculaire à ladite face d'éclairement est supérieure ou égale à une longueur d'absorption $L_{abs}$ dudit rayonnement électroluminescent ($L_d$) par ledit concentrateur.

5. Dispositif selon l'une quelconque des revendications 1 à 2, dans lequel l'élément déclencheur de luminescence comprend un élément chauffant configuré pour chauffer ledit cristal concentrateur pour qu'il émette ledit rayonnement de luminescence par thermoluminescence.

6. Dispositif selon l'une quelconque des revendications 1 à 2, dans lequel l'élément déclencheur de luminescence comprend une lentille adaptée pour focaliser un rayonnement solaire sur une face dite d'éclairement (SI1, SI2) du concentrateur, ledit concentrateur étant adapté pour absorber ledit rayonnement solaire puis émettre un rayonnement de fluorescence correspondant audit rayonnement de luminescence.

7. Dispositif selon l'une quelconque des revendications précédentes, dans lequel le cristal concentrateur présente une arête biseautée située entre la première face latérale et une autre face dudit cristal concentrateur, une surface de l'arête biseautée étant considérée comme faisant partie de la surface de la première face latérale pour le calcul dudit ratio R, au moins une portion d'une surface de l'arête biseautée n'étant pas recouverte et définissant une face de sortie associée.

8. Dispositif selon l'une quelconque des revendications 1 à 6, dans lequel le cristal concentrateur présente un coin biseauté situé entre la première face latérale et deux autres faces dudit cristal concentrateur, une surface du coin biseautée étant considérée comme faisant partie de la surface de la première face latérale pour le calcul dudit ratio R, au moins une portion de ladite surface du coin biseautée n'étant pas recouverte et définissant une face de sortie associée.

9. Dispositif selon l'une quelconque des revendications 1 à 8, dans lequel ledit premier miroir est adapté pour définir $n \geq 1$ surfaces non recouvertes, définissant n faces de sortie (FS1$_i$,) traversées par *n* faisceaux de sortie ($L_{out,1}$, $L_{out,2}$), ledit dispositif comprenant en outre :

- *n* fibres optiques (FO$_i$) et
- *n* systèmes optiques de couplage (SC$_i$) chacun

adapté pour coupler un faisceau de sortie dans une fibre optique différente.

**10.** Dispositif selon la revendication précédente, dans lequel le premier miroir (M1) est adapté pour qu'une étendue géométrique de chaque faisceau de sortie soit sensiblement égale à une étendue géométrique de ladite fibre optique couplant ledit faisceau de sortie.

**11.** Dispositif selon l'une quelconque des revendications précédentes, comprenant deux miroirs additionnels (M3, M4) couvrant deux faces parallèles dites tranches du concentrateur, lesdits deux miroirs additionnels étant agencés de manière à couvrir la totalité des tranches.

**12.** Dispositif selon l'une quelconque des revendications précédentes, comprenant un premier et un second module d'émission (ME1, ME2) et un premier élément déclencheur de luminescence associé au premier module d'émission, une face du cristal concentrateur (CL2) du second module d'émission différente d'une face latérale étant accolée à une face de sortie ($FS1_1$) du cristal concentrateur (CL1) dudit premier module d'émission, de manière à ce que le premier faisceau de sortie ($L_{out,1}$) du premier module d'émission, dit rayonnement de luminescence primaire, constitue l'élément déclencheur de luminescence du deuxième module d'émission, le deuxième module d'émission générant un deuxième faisceau de sortie ($L_{out,2}$) dit rayonnement de luminescence secondaire, présentant une longueur d'onde centrale décalée par rapport à une longueur d'onde centrale dudit rayonnement de luminescence primaire.

**13.** Dispositif selon la revendication précédente, dans lequel des dimensions dudit second module dans un plan vertical *yz* parallèle à ladite face de sortie du cristal concentrateur dudit premier module sont inférieures ou égales à des dimensions de ladite face de sortie du concentrateur dudit premier module d'émission.

**14.** Dispositif selon l'une quelconque des revendications 12 à 13, dans lequel une dimension dudit concentrateur du second module selon ladite direction x est supérieure à une longueur d'absorption $L_{abs,2}$ dudit rayonnement de luminescence primaire par ledit concentrateur dudit second module.

**15.** Dispositif selon l'une quelconque des revendications précédentes, dans lequel ledit premier miroir est monté sur un système de translation (ST) adapté pour déplacer ledit premier miroir relativement à ladite première face latérale de manière à réduire ou accroitre la surface non recouverte.

**16.** Dispositif selon l'une quelconque des revendications 1 à 15, dans lequel ledit premier miroir est adapté pour que la forme d'une surface non recouverte soit carré, rectangulaire, circulaire, elliptique, triangulaire ou encore polygonale.

**Patentansprüche**

**1.** Lichtemissionsvorrichtung (1), umfassend:

- mindestens ein Emissionsmodul (ME), umfassend:

- einen Lumineszenzkristall, genannt Konzentratorkristall (CL), der mindestens sechs paarweise parallele Flächen aufweist, darunter eine erste und eine zweite sogenannte Seitenfläche (FL1, FL2), die senkrecht zu einer x-Richtung stehen und durch einen Abstand L getrennt sind, der einer horizontalen Abmessung des Konzentrators in der Richtung x entspricht;
- einen ersten Spiegel (M1), der konfiguriert ist, um die erste Seitenfläche (FL1) teilweise zu bedecken, wobei eine durch den ersten Spiegel verdeckte Oberfläche (SR1) und mindestens eine durch den ersten Spiegel nicht verdeckte Oberfläche (SFS1) definiert wird, die eine zugeordnete Austrittsfläche (FS1, $FS1_1$, $FS1_2$) definiert,
- einen zweiten Spiegel (M2), der konfiguriert ist, um mindestens 95 % der zweiten Seitenfläche (FL2) zu bedecken,

- ein Lumineszenzauslöseelement (ED), das zum Erzeugen einer Emission einer Lumineszenzstrahlung ($L_F$) in dem Lumineszenzkristall angepasst ist;

wobei ein Verhältnis R zwischen der nicht verdeckten Oberfläche (SFS1) und der Gesamtoberfläche ($S_L$) der ersten Seitenfläche (FL1) so bestimmt ist, dass Strahlen der Lumineszenzstrahlung an dem ersten und dem zweiten Spiegel reflektiert werden und sich über eine mittlere Entfernung $L_{moy}$ ausbreiten, sodass $L_p = \dfrac{1}{\alpha} > L_{moy} \gg L$ innerhalb des Lumineszenzkristalls, bevor sie mindestens eine Austrittsfläche ($FS1_1$, $FS1_2$) durchqueren, wobei ein Austrittsstrahl ($L_{out}$) ausgebildet wird, wobei das Verhältnis R kleiner als oder gleich 1/4 ist, mit $\alpha$ dem Verlustkoeffizienten pro Längeneinheit des Konzentrators für die Lumineszenzstrahlung, definiert als linearer Dämpfungskoeffizient des Faktors e.

**2.** Vorrichtung nach Anspruch 1, wobei das Verhältnis R kleiner als oder gleich 1/8 ist.

3. Vorrichtung nach einem der Ansprüche 1 bis 2, wobei das Lumineszenzauslöseelement eine Vielzahl von Lumineszenzdioden (LED) oder Lasern oder Blitzlampen umfasst, die zum Emittieren einer elektrolumineszenten Strahlung ($L_d$) bei einer Wellenlänge $\lambda_d$ konfiguriert sind, wobei die Dioden angeordnet sind, um mindestens eine sogenannte Beleuchtungsfläche (SI1, SI2) des Konzentrators zu beleuchten, wobei der Konzentrator ein fluoreszenter Kristall ist, der zum Absorbieren der elektrolumineszenten Strahlung ($L_d$), dann Emittieren einer Fluoreszenzstrahlung konfiguriert ist, die der Lumineszenzstrahlung entspricht.

4. Vorrichtung nach Anspruch 3, wobei eine vertikale Abmessung e des Konzentrators in einer Richtung $z$ senkrecht zu der Beleuchtungsfläche größer als oder gleich einer Absorptionslänge $L_{abs}$ der elektrolumineszenten Strahlung ($L_d$) durch den Konzentrator ist.

5. Vorrichtung nach einem der Ansprüche 1 bis 2, wobei das Lumineszenzauslöseelement ein Heizelement umfasst, das zum Erhitzen des Konzentratorkristalls konfiguriert ist, damit er die Lumineszenzstrahlung durch Thermolumineszenz emittiert.

6. Vorrichtung nach einem der Ansprüche 1 bis 2, wobei das Lumineszenzauslöseelement eine Linse umfasst, die zum Fokussieren einer Sonnenstrahlung auf eine sogenannte Beleuchtungsfläche (SI1, SI2) des Konzentrators angepasst ist, wobei der Konzentrator zum Absorbieren der Sonnenstrahlung, dann Emittieren einer Fluoreszenzstrahlung angepasst ist, die der Lumineszenzstrahlung entspricht.

7. Vorrichtung nach einem der vorstehenden Ansprüche, wobei der Konzentratorkristall eine abgeschrägte Kante aufweist, die zwischen der ersten Seitenfläche und einer anderen Fläche des Konzentratorkristalls gelegen ist, wobei eine Oberfläche der abgeschrägten Kante als Teil der Oberfläche der ersten Seitenfläche für die Berechnung des Verhältnisses R betrachtet wird, wobei mindestens ein Abschnitt einer Oberfläche der abgeschrägten Kante nicht verdeckt ist und eine zugeordnete Austrittsfläche definiert.

8. Vorrichtung nach einem der Ansprüche 1 bis 6, wobei der Konzentratorkristall eine abgeschrägte Ecke aufweist, die zwischen der ersten Seitenfläche und zwei anderen Flächen des Konzentratorkristalls gelegen ist, wobei eine Oberfläche der abgeschrägten Ecke als Teil der Oberfläche der ersten Seitenfläche für die Berechnung des Verhältnisses R betrachtet wird, wobei mindestens ein Abschnitt der Oberfläche der abgeschrägten Ecke nicht verdeckt ist und eine zugeordnete Austrittsfläche definiert.

9. Vorrichtung nach einem der Ansprüche 1 bis 8, wobei der erste Spiegel zum Definieren von $n \geq 1$ nicht verdeckten Oberflächen konfiguriert ist, die n Austrittsflächen ($FS1_i$,) definieren, die von $n$ Austrittsstrahlen ($L_{out1}$, $L_{out,2}$) durchquert werden, die Vorrichtung ferner umfassend:

- $n$ optische Fasern ($FO_i$) und
- $n$ optische Kopplungssysteme ($SC_i$), die jeweils zum Koppeln eines Ausgangsstrahls in eine unterschiedliche Lichtleitfaser konfiguriert sind.

10. Vorrichtung nach dem vorstehenden Anspruch, wobei der erste Spiegel (M1) dafür angepasst ist, dass eine geometrische Ausdehnung jedes Ausgangsstrahls im Wesentlichen gleich einer geometrischen Ausdehnung der optischen Faser ist, die den Ausgangsstrahl koppelt.

11. Vorrichtung nach einem der vorstehenden Ansprüche, umfassend zwei zusätzliche Spiegel (M3, M4), die zwei parallele Flächen, sogenannte Kanten des Konzentrators, abdecken, wobei die zwei zusätzlichen Spiegel angeordnet sind, um die Gesamtheit der Kanten abzudecken.

12. Vorrichtung nach einem der vorstehenden Ansprüche, umfassend ein erstes und ein zweites Emissionsmodul (ME1, ME2) und ein erstes Lumineszenzauslöseelement, das dem ersten Emissionsmodul zugeordnet ist, wobei eine Fläche des Konzentratorkristalls (CL2) des zweiten Emissionsmoduls, die sich von einer Seitenfläche unterscheidet, an eine Ausgangsfläche ($FS1_1$) des Konzentratorkristalls (CL1) des ersten Emissionsmoduls angefügt ist, derart, dass der erste Ausgangsstrahl ($L_{out,1}$) des ersten Emissionsmoduls, genannt primäre Lumineszenzstrahlung, das Lumineszenzauslöseelement des zweiten Emissionsmoduls ausbildet, wobei das zweite Emissionsmodul einen zweiten Ausgangsstrahl ($L_{out,2}$) erzeugt, genannt sekundäre Lumineszenzstrahlung, der eine zentrale Wellenlänge aufweist, die gegenüber einer zentralen Wellenlänge der primären Lumineszenzstrahlung verschoben ist.

13. Vorrichtung nach dem vorstehenden Anspruch, wobei Abmessungen des zweiten Moduls in einer vertikalen Ebene yz parallel zu der Austrittsfläche des Konzentratorkristalls des ersten Moduls kleiner als oder gleich Abmessungen der Austrittsfläche des Konzentrators des ersten Emissionsmoduls sind.

14. Vorrichtung nach einem der Ansprüche 12 bis 13, wobei eine Abmessung des Konzentrators des zweiten Moduls in der Richtung *x* größer als eine Absorptionslänge $L_{abs,2}$ der primären Lumineszenzstrahlung durch den Konzentrator des zweiten Moduls ist.

15. Vorrichtung nach einem der vorstehenden Ansprüche, wobei der erste Spiegel auf einem Translationssystem (ST) montiert ist, das zum Bewegen des ersten Spiegels relativ zu der ersten Seitenfläche angepasst ist, um die nicht verdeckte Oberfläche zu verringern oder zu vergrößern.

16. Vorrichtung nach einem der Ansprüche 1 bis 15, wobei der erste Spiegel dafür angepasst ist, dass die Form einer nicht bedeckten Oberfläche quadratisch, rechteckig, kreisförmig, elliptisch, dreieckig oder polygonal ist.

**Claims**

1. A light-emission device (1) comprising:

    - at least one emission module (ME) comprising:

        - a luminescent crystal known as a concentrator crystal (CL) with at least six faces which are parallel in pairs, including a first and a second face, known as lateral faces (FL1, FL2), perpendicular to a direction x and separated by a distance L corresponding to a horizontal dimension of said concentrator in the direction *x*;
        - a first mirror (M1), which is configured such as to cover partly said first lateral face (FL1), defining a surface area (SR1) covered by said first mirror, and at least one surface area (SFS1) which is not covered by said first mirror defining an associated output face (FS1, FS1$_1$, FS1$_2$);
        - a second mirror (M2), which is configured such as to cover at least 95% of said second lateral face (FL2);

        - a luminescence triggering element (ED), which is designed to generate emission of luminescence radiation ($L_F$) in said luminescent crystal; a ratio R between the non-covered surface area (SFS1) and the total surface area (S$_L$) of the first lateral face (FL1) being determined such that rays of the luminescence radiation are reflected on said first and second mirrors, and are propagated over a mean distance $L_{moy}$ such that

$$L_p = \frac{1}{\alpha} > L_{moy} \gg L$$ within the luminescent crystal before passing through at least one output face (FS1$_1$, FS1$_2$), forming an output beam (L$_{out}$), said ratio R being 1/4 or less, where

$\alpha$ is the coefficient of loss per unit of length of said concentrator for said luminescence radiation defined as the linear attenuation coefficient of factor e.

2. The device as claimed in claim 1, wherein said ratio R is 1/8 or less.

3. The device as claimed in either one of claims 1 and 2, wherein the luminescence triggering element comprises a plurality of light-emitting diodes (LED) or lasers or flash lamps which are configured to emit light-emitting radiation ($L_d$) at a wavelength $\lambda_d$, said diodes being designed such as to illuminate at least one face known as the lighting face (SI1, SI2) of the concentrator, said concentrator being a fluorescent crystal designed to absorb said light-emitting radiation ($L_d$), then emit fluorescence radiation corresponding to said luminescence radiation.

4. The device as claimed in claim 3, wherein a vertical dimension *e* of the concentrator in a direction *z* perpendicular to said lighting face is greater than, or equal to, a length of absorption $L_{abs}$ of said light-emitting radiation ($L_d$) by said concentrator.

5. The device as claimed in any one of claims 1 and 2, wherein the luminescence triggering element comprises a heating element which is configured to heat said concentrator crystal such that it emits said luminescence radiation by thermoluminescence.

6. The device as claimed in any one of claims 1 and 2, wherein the luminescence triggering element comprises a lens, which is designed to focus solar radiation on a so-called lighting face (SI1, SI2) of the concentrator, said concentrator being designed to absorb said solar radiation, then emit fluorescence radiation corresponding to said luminescence radiation.

7. The device as claimed in any one of the preceding claims, wherein the concentrator crystal has a beveled edge situated between the first lateral face and another face of said concentrator crystal, a surface area of the beveled edge being considered as forming part of the surface area of the first lateral face for calculation of said ratio R, at least one portion of a surface area of the beveled edge not being covered and defining an associated output face.

8. The device as claimed in any one of claims 1 to 6, wherein the concentrator crystal has a beveled corner situated between the first lateral face and two other faces of said concentrator crystal, a surface area of the beveled corner being considered as forming part of the surface area of the first lateral face for calculation of said ratio R, at least one portion of said surface area of the beveled corner not being covered, and defining an associated output face.

9. The device as claimed in any one of claims 1 to 8, wherein said first mirror is designed to define $n \geq 1$ non-covered surface areas, defining n output faces ($FS1_i$) through which $n$ output beams ($L_{out,1}$, $L_{out,2}$) pass, said device also comprising:

   - $n$ optical fibers ($FO_i$); and
   - $n$ optical coupling systems ($SC_i$), each designed to couple an output beam in a different optical fiber.

10. The device as claimed in the preceding claim, wherein the first mirror (M1) is designed such that a geometric extent of each output beam is substantially equal to a geometric extent of said optical fiber coupling said output beam.

11. The device as claimed in any one of the preceding claims, comprising two additional mirrors (M3, M4) covering two parallel faces known as sections of the concentrator, said two additional mirrors being designed such as to cover all of the sections.

12. The device as claimed in any one of the preceding claims, comprising a first and a second emission module (ME1, ME2) and a first luminescence triggering element which is associated with the first emission module, a face of the concentrator crystal (CL2) of the second emission module, different from a lateral face, being attached to an output face ($FS1_1$) of the concentrator crystal (CL1) of said first emission module, such that the first output beam ($L_{out,1}$) of the first emission module, known as the primary luminescence radiation, constitutes the luminescence triggering element of the second emission module, with the second emission module generating a second output beam ($L_{out,2}$), known as the secondary luminescence radiation, having a central wavelength which is offset relative to a central wavelength of said primary luminescence radiation.

13. The device as claimed in the preceding claim, wherein dimensions of said second module on a vertical plane *yz* parallel to said output face of the concentrator crystal of said first module are smaller than, or equal to, dimensions of said output face of the concentrator of said first emission module.

14. The device as claimed in either one of claims 12 and 13, wherein a dimension of said concentrator of the second module in said direction *x* is greater than a length of absorption $L_{abs,2}$ of said primary luminescence radiation by said concentrator of said second module.

15. The device as claimed in any one of the preceding claims, wherein said first mirror is fitted on a translation system (ST) which is designed to displace said first mirror relative to said first lateral face, such as to reduce or increase the non-covered surface area.

16. The device as claimed in any one of claims 1 to 15, wherein said first mirror is designed such that the form of a non-covered surface area is square, rectangular, circular, elliptical, triangular, or also polygonal.

[Fig.1A]

FIG.1A

[Fig.1B]

FIG.1B

[Fig.1C]

FIG.1C

[Fig.1D]

Fig.1D

[Fig.1E]

Fig.1E

[Fig.2]

Fig.2

[Fig.3A]

Fig.3A

[Fig.3B]

Fig.3B

[Fig.4]

Fig.4

[Fig.5A]

Fig.5A

[Fig.5B]

Fig.5B

[Fig.5C]

Fig.5C

[Fig.6A]

Fig.6A

[Fig.6B]

Fig.6B

[Fig.7A]

Fig.7A

[Fig.7B]

Fig.7B

[Fig.8]

Fig.8

[Fig.9]

Fig.9

[Fig.10A]

Fig.10A

[Fig.10B]

M2

$L_d$

A   FS1

CL

M1,FL1

# Fig.10B

[Fig.11]

Fig.11

[Fig.12]

Fig.12

[Fig.13A]

Fig.13A

[Fig.13B]

Fig.13B

[Fig.14]

Fig.14

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2947484 A1

- US 2007280622 A1

**Littérature non-brevet citée dans la description**

- **BARBET, ADRIEN et al.** Light-emitting diode pumped luminescent concentrators: a new opportunity for low-cost solid-state lasers. *Optica*, 2016, vol. 3 (5), 465-468
- **MEINARDI, FRANCESCO et al.** Large-area luminescent solar concentrators based on 'Stokes-shift-engineered'nanocrystals in a mass-polymerized PMMA matrix.. *Nature Photonics*, 2014, vol. 8 (5), 392

- **D. K. G. DE BOER ; D. BRULS ; H. JAGT**. High-brightness source based on luminescent concentration. *Optics Express*, July 2016, vol. 24 (14), A1069